# EUROPÄISCHE PATENTANMELDUNG

(11) **EP 0 807 963 A2**
(43) Veröffentlichungstag der Anmeldung: **19.11.1997**
(21) Anmeldenummer: 97107122.0
(22) Anmeldetag: 29.04.1997
(51) Int. Cl.: H01L 21/304, H01L 21/78, B28D 5/00

(54) **Verfahren zum Bearbeiten von Seitenflächen elektronischer Elemente**

(30) Priorität: 10.05.1996 DE 19618895
(71) Anmelder: ITT MANUFACTURING ENTERPRISES, INC., Wilmington, Delaware 19801 (US)
(72) Erfinder: Igel, Günter, 79331 Teningen (DE); Mall, Martin, Dr., 79100 Freiburg (DE)
(74) Vertreter: Hornig, Leonore, Dr.

(57) **Zusammenfassung**

Die Erfindung betrifft ein Verfahren zum Bearbeiten von Seitenflächen elektronischer Elemente 1, bei dem die elektronischen Elemente 1 auf der Vorderseite eines Körpers ausgebildet sind, der Körper ausgehend von seiner Rückseite abgedünnt wird, die Vorderseite und die abgedünnte Rückseite des Körpers mit einer Hilfsschicht 7 versehen wird, die elektronischen Elemente 1 von der der Hilfsschicht 7 abgewandten Seite des Körpers ausgehend soweit voneinander getrennt werden, daß der größte Teil ihrer jeweiligen Seitenflächen 8 freiliegt, und die elektronischen Elemente 1 durch zumindest einen Teil der Hilfsschicht 7 mechanisch zusammengehalten werden, und daß die freiliegenden Teile der Seitenflächen 8 bearbeitet werden.

## Beschreibung

Die Erfindung betrifft ein Verfahren zum Bearbeiten von Seitenflächen elektronischer Elemente.

Das Bearbeiten von Seitenflächen elektronischer Elemente ist in der Praxis problematisch. Da elektronische Elemente in einem Körper hergestellt werden, in welchem sie miteinander verbunden sind, sind ihre Seitenflächen einer Bearbeitung nicht zugänglich. Wenn die elektronischen Elemente aus dem Körper herausgetrennt sind und einzeln vorliegen, sind sie so klein, daß sie nicht mehr ohne weiteres gehandhabt und bearbeitet werden können. In der Halbleitertechnologie werden die elektronischen Elemente auf der Vorderseite eines Halbleiterwafers durch Einbringen von aktiven Gebieten ausgebildet. Danach wird der Halbleiterwafer abgedünnt, gegebenenfalls wird seine Rückseite metallisiert. Die elektronischen Elemente werden beispielsweise durch Sägen voneinander getrennt.

Der Erfindung liegt die Aufgabe zugrunde, ein Verfahren zu schaffen, mit dem die Seitenflächen elektronischer Elemente bearbeitet werden können.

Die Aufgabe wird durch ein Verfahren zum Bearbeiten von Seitenflächen elektronischer Elemente gelöst, bei dem die elektronischen Elemente auf einer Vorderseite eines Körpers ausgebildet sind, der Körper ausgehend von seiner Rückseite abgedünnt wird, die Vorderseite oder die abgedünnte Rückseite des Körpers mit einer Hilfsschicht versehen wird, die elektronischen Elemente von der der Hilfsschicht abgewandten Seite des Körpers ausgehend soweit voneinander getrennt werden, daß der größte Teil ihrer jeweiligen Seitenflächen freiliegt und sie durch zumindest einen Teil der Hilfsschicht mechanisch zusammengehalten werden, und daß die freiliegenden Teile der Seitenflächen bearbeitet werden.

Bei dem erfindungsgemäßen Verfahren dient die Hilfsschicht dazu, die elektronischen Elemente mechanisch zusammenzuhalten, so daß sie im Verbund bleiben, mechanisch gehandhabt und weiterverarbeitet werden können. Aufgrund des durchgeführten Trennvorgangs liegt der größte Teil der Seitenflächen der elektronischen Elemente frei, so daß dieser einer Bearbeitung zugänglich ist. Nach dem Bearbeiten der Seitenflächen können die elektronischen Elemente dann vollständig voneinander getrennt werden.

Gemäß einer vorteilhaften Weiterbildung der Erfindung wird der Abstand zwischen benachbarten elektronischen Elementen bzw. der Öffnungswinkel, dessen Schenkel durch die Seitenflächen benachbarter elektronischer Elemente gebildet wird, vor dem Bearbeiten der Seitenflächen vergrößert. Hierdurch werden die Seitenflächen der elektronischen Elemente der Bearbeitung leichter zugänglich. Dabei sind die elektronischen Elemente gut handhabbar, da sie mit der Hilfsschicht mechanisch miteinander verbunden sind und somit zusammengehalten werden. Das Vergrößern des Abstandes bzw. des Öffnungswinkels ist insbesondere dann vorteilhaft, wenn das Aspektverhältnis der Trennbereiche zwischen den elektronischen Elementen, d.h. das Verhältnis der Tiefe der Trennbereiche zu der Breite der Trennbereiche, groß ist. Je größer dieses Aspektverhältnis ist, um so schwieriger wird eine Bearbeitung der Seitenflächen der elektronischen Elemente, da insbesondere die Bereiche der Seitenflächen, die von der Oberfläche entfernt liegen, der Bearbeitung nicht mehr zugänglich sind. Es ist in der Praxis möglich, den Abstand zwischen benachbarten elektronischen Elementen, beispielweise durch Recken der Hilfsschicht, zu vergrößern. Es ist auch möglich, den Öffnungswinkel durch Biegen der Hilfsschicht mit den sich darauf befindenden elektronischen Elementen zu vergrößern. Ebenfalls können der Abstand und der Öffnungswinkel gleichzeitig vergrößert werden. Dieses Verfahren ist insbesondere in der Halbleitertechnologie vorteilhaft, da dort, um Material zu sparen, möglichst kleine Trennbereiche wünschenswert sind.

Gemäß einem vorteilhaften Ausführungsbeispiel der Erfindung werden die elektronischen Elemente zum Vergrößern des Öffnungswinkels reihenweise über einen Gegenstand geführt, der entlang den jeweiligen Reihen eine Drehachse definiert und einen vorgegebenen Krümmungsradius aufweist. In diesem Fall können die Seitenflächen jeweils einer Reihe von elektronischen Elementen gleichzeitig bearbeitet werden. Es können so nacheinander alle in einer Richtung liegenden Reihen bearbeitet werden. Danach kann beispielsweise, wenn es sich um rechtwinklige elektronische Elemente handelt, die Hilfsschicht mit den sich darauf befindenden elektronischen Elementen um 90° gedreht werden. Die elektronischen Elemente können dann zum Vergrößern des Öffnungswinkels erneut reihenweise über den Gegenstand geführt werden, so daß die verbleibenden Seitenflächen der elektronischen Elemente ebenfalls bearbeitet werden können.

Das Bearbeiten der Seitenflächen kann günstigerweise durch Beschichten, insbesondere durch Metallisieren, durch Abtragen von Material, durch Belichten und/oder durch Dotieren erfolgen. Das Beschichten der Seitenflächen kann bevorzugterweise durch stromloses, galvanisches Abscheiden eines Metalls erfolgen. Zur Metallisierung können beispielsweise Nickel, Kupfer oder Paladium verwendet werden.

Gemäß einem Ausführungsbeispiel der Erfindung kann das abzuscheidende Metall in einer chemischen Lösung mittels eines flüssigen Strahls auf die Seitenflächen aufgebracht und die überschüssige chemische Lösung gleichzeitig abgesaugt werden.

Gemäß einem weiteren Ausführungsbeispiel der Erfindung kann die Metallisierung durch Bedampfen oder Sputtern durch eine Blende erfolgen, die so angeordnet ist, daß die Oberfläche der elektronischen Elemente nicht metallisiert wird. Dies ist dann vorteilhaft, wenn nur die Seitenflächen metallisiert werden sollen. Mit der Blende kann verhindert werden, daß das Metall auch auf die Oberfläche der elektronischen Elemente gelangt. Es kann dann eine elektronische Steuerung vorgesehen sein, die die Blende immer dann öffnet, wenn die elektronischen Elemente sich in einer bestimmten Position bezüglich der Blende befinden.

Bevorzugterweise kann wenigstens eine weitere Metallschicht auf die metallisierten Seitenflächen aufgebracht werden. Wenn das Aufbringen galvanisch erfolgt, kann beispielsweise immer ein edleres Metall auf ein unedleres aufgebracht werden.

Es kann auch vorteilhaft sein, wenn gleichzeitig mit dem Metallisieren der Seitenflächen der elektronischen Elemente ihre Rückseite metallisiert wird. Hierdurch wird ein zusätzlicher Arbeitsschritt für die Rückseitenmetallisierung gespart. Auch wird das Metallisieren dadurch vereinfacht, daß es nicht gerichtet auf bestimmte Teile, d.h. die Seitenflächen, aufgebracht werden muß.

Die Hilfsschicht kann nach dem Bearbeiten der Seitenflächen zwischen den elektronischen Elementen durchtrennt werden. Vor diesem Vereinzeln der elektronischen Elemente können noch weitere Verfahrensschritte durchgeführt werden.

Gemäß einem Ausführungsbeispiel der Erfindung wird die Hilfsschicht auf der Vorderseite des Körpers aufgebracht, in der Hilfsschicht werden Öffnungen über den Kontakten der elektronischen Elemente vorgesehen, und elektrische Parameter der elektronischen Elemente werden vor dem Durchtrennen der Hilfsschicht getestet. In diesem Fall ist das Testen der elektrischen Parameter der einzelnen elektronischen Elemente vor dem Durchtrennen der Hilfsschicht auch dann möglich, wenn die Seitenflächen der elektronischen Elemente galvanisch metallisiert worden sind. Denn bei der galvanischen Metallisierung werden zwar die Seitenflächen der elektronischen Elemente, nicht aber die Folie, wenn diese aus einem geeigneten Material gewählt ist, beschichtet.

Gemäß einem anderen Ausführungsbeispiel der Erfindung wird die Hilfsschicht auf der Rückseite des abgedünnten Körpers aufgebracht, das Trennen der elektronischen Elemente erfolgt bis zu der Hilfsschicht und elektrische Parameter der elektronischen Elemente werden vor dem Durchtrennen der Hilfsschicht getestet. Auch in diesem Ausführungsbeispiel kann das Testen der elektrischen Parameter der einzelnen elektronischen Elemente erfolgen, wenn die Seitenflächen galvanisch metallisiert worden sind, da das Metall auf der Hilfsschicht nicht haften bleibt. Da sich die elektronischen Elemente noch im Verbund befinden, können sie zum Testen der Parameter leicht gehandhabt werden.

Gemäß einem Ausführungsbeispiel der Erfindung kann der Körper ein Halbleiterwafer sein, in dem die elektronischen Elemente miteinander verbunden sind.

Im folgenden wird die Erfindung anhand der Figur näher beschrieben.

Es zeigen:
Fig. 1 elektronische Elemente, die auf der Rückseite mit einer Hilfsschicht miteinander verbunden sind,
Fig. 2 die elektronischen Elemente der Figur 1, nachdem zwischen ihnen ein Trennbereich ausgebildet worden ist,
Fig. 3 die elektronischen Elemente der Fig. 1 und 2, nachdem sie gegeneinander gedreht worden sind,
Fig. 4 elektronische Elemente, die auf ihrer Vorderseite mit einer Hilfsschicht verbunden sind,
Fig. 5 die elektronischen Elemente der Fig. 4, nachdem zwischen ihnen ein Trennbereich ausgebildet worden ist und
Fig. 6 die elektronischen Elemente der Fig. 4 und 5, nachdem sie gegeneinander gedreht worden sind.

Im folgenden wird das erfindungsgemäße Verfahren am Beispiel von elektronischen Elementen, die in einem Halbleiterwafer miteinander verbunden sein können, erläutert.

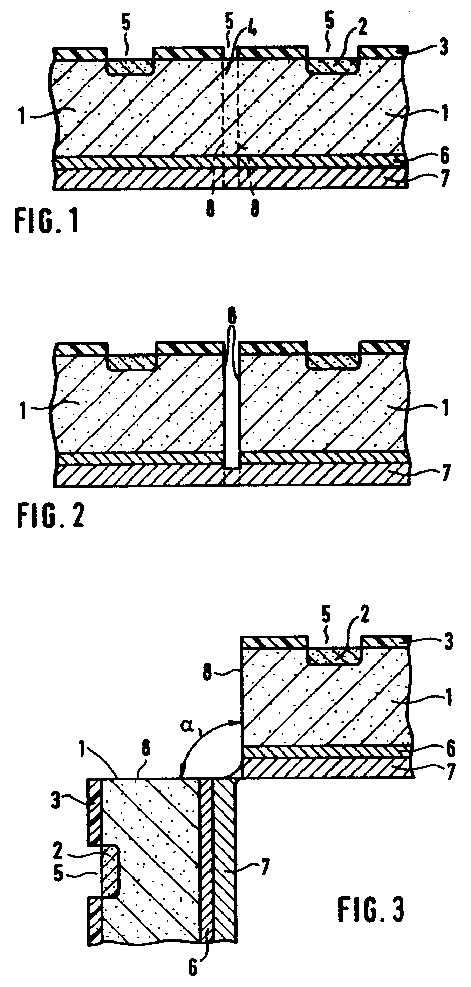

In Fig. 1 ist ein Ausschnitt aus einem solchen Halbleiterwafer gezeigt, der zwei elektronische Elemente 1 im Querschnitt zeigt. In den elektronischen Elementen 1 ist jeweils ein aktiver Bereich 2 ausgebildet. Dieser kann beispielsweise ein dotierter Bereich sein, der vom entgegengesetzten Dotierungstyp wie das Substrat des elektronischen Elements 1 ist, so daß ein pn-Übergang entsteht. Die aktiven Bereiche 2 sind auf der Vorderseite des elektronischen Elements 1 ausgebildet. Ferner ist die Vorderseite mit einer Schutzschicht 3 versehen, die über den aktiven Bereichen 2 und über den Trennbereichen 4 Öffnungen 5 aufweist. Ferner sind die elektronischen Elemente 1 abgedünnt, und auf ihrer Rückseite ist eine Metallschicht 6 aufgebracht. Die elektronischen Elemente 1 sind auf einer Hilfssicht 7 aufgebracht. Die Hilfsschicht 7 muß eine mechanische Stabilität aufweisen, die so groß ist, daß sie die elektronischen Elemente 1 zusammenhält. Die Art der Hilfsschicht wird abhängig vom Einzelfall, d.h. von der Art der elektronischen Elemente gewählt. Es kann eine elektrisch isolierende Folie verwendet werden, für bestimmte Anwendungen kann es aber auch zweckmäßig sein, eine Metallfolie zu verwenden.

Fig. 2 zeigt die elektronischen Elemente 1 der Fig. 1. Sie sind ausgehend von der Vorderseite soweit voneinander getrennt, daß der größte Teil ihrer Seitenflächen 8 freiliegt. Die elektronischen Elemente 1 sind mechanisch durch die Hilfsschicht 7 zusammengehalten. Zum Freilegen der Seitenflächen 8 muß der Trennbereich 4 abgetragen werden. Das Abtragen des Materials des Trennbereichs 4 kann durch mechanisches Abtragen wie Sägen, durch gerichtetes Ätzen, insbesondere Plasmaätzen oder durch ein sonstiges geeignetes Trennverfahren erfolgen. Der Trennbereich 4 ist, um Halbleitermaterial zu sparen, möglichst schmal gewählt, und weist somit ein sehr hohes Aspektverhältnis auf.

Fig. 3 zeigt die elektronischen Elemente 1 der Fig. 1 und 2 nach einem weiteren Verfahrensschritt. Sie sind mit der Hilfsschicht 7 mechanisch miteinander verbunden. Die beiden zueinander benachbarten elektronischen Elemente 1 sind so gegeneinander gedreht, daß ein Öffnungswinkel α von 90°, dessen Schenkel durch die Seitenflächen 8 der benachbarten elektronischen Elemente 1 gebildet wird, entsteht. Die Seitenflächen 8 sind somit einer Bearbeitung leicht zugänglich. Sie können in diesem Zustand z.B. beschichet werden, es kann Material abgetragen werden, sie können belichtet werden oder dotiert werden. Danach können die elektrischen Parameter der elektronischen Elemente 1 durch Kontaktieren der aktiven Bereiche 2 in den Durchbrechungen 5 getestet werden. Das Vereinzeln der elektronischen Elemente 1 erfolgt durch Durchtrennen der verbleibenden Hilfsschicht 7 in dem Trennbereich 4.

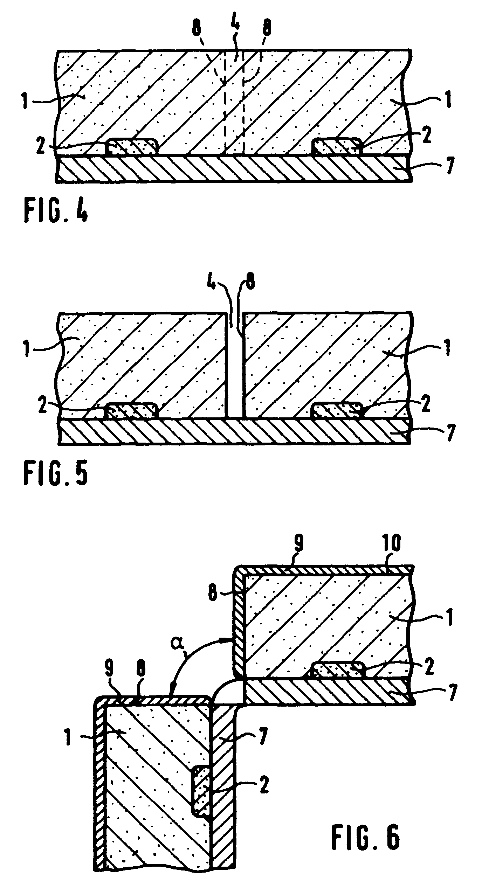

Fig. 4 zeigt zwei elektronische Elemente 1 im Querschnitt. Die Vorderseite mit den aktiven Bereichen 2 ist auf einer Hilfsschicht 7 aufgebracht. Die Rückseite der elektronischen Elemente ist bereits abgedünnt. Es ist ein Trennbereich 4 eingezeichnet, der die Seitenflächen 8 der elektronischen Elemente 1 begrenzt.

Fig. 5 zeigt die elektronischen Elemente 1, nachdem sie durch Materialabtrag in dem Trennbereich 4 voneinander bis zu der Hilfsschicht 7 getrennt sind. Durch die Hilfsschicht 7 werden sie mechanisch zusammengehalten.

In Fig. 6 sind die benachbarten elektronischen Elemente 1 gegeneinander um den Winkel α von 90° gedreht. Der Winkel α ist der Öffnungswinkel, dessen Schenkel durch die Seitenflächen der benachbarten elektronischen Elemente 1 gebildet wird. Auf die Seitenflächen 8, die in diesem Zustand einer Bearbeitung leicht zugänglich sind, ist eine Schicht 9 aufgebracht, die in dem gezeigten Beispiel eine Metallschicht ist. Die Metallschicht 9 ist in dem gezeigten Beispiel gleichzeitig auf die Rückseite der elektronischen Elemente 1 aufgebracht, so daß die Metallisierung der Seitenflächen 8 und der Rückseite 10 in einem Arbeitsschritt erfolgen kann. Bei der gezeigten Hilfsschicht 7 handelt es sich um eine Isolatorschicht. Da die Metallschicht 9 mit einem geeigneten Verfahren, beispielsweise durch galvanisches Abscheiden des Metalls aufgebracht wurde, bleibt das Metall lediglich auf den Seitenflächen 8 der elektronischen Elemente 1 und nicht auf der Hilfsschicht 7 haften. Somit sind die elektronischen Elemente 1 mit der Schicht 9 aus Metall elektrisch voneinander isoliert. Wenn in der Hilfsschicht 7 oberhalb der aktiven Bereiche 2 Öffnungen ausgebildet werden, können die elektrischen Parameter der einzelnen elektronischen Elemente 1 im Verbund und unabhängig voneiander getestet werden. Das mechanische Trennen der elektronischen Elemente 1 voneinander erfolgt durch Trennen der in dem Trennbereich 4 verbleibenden Hilfsschicht 7.

## Patentansprüche

1. Verfahren zum Bearbeiten von Seitenflächen elektronischer Elemente (1),bei dem die elektronischen Elemente (1) auf einer Vorderseite eines Körper ausgebildet sind, der Körper ausgehend von seiner Rückseite abgedünnt wird, die Vorderseite oder die abgedünnte Rückseite des Körpers mit einer Hilfsschicht (7) versehen wird, die elektronischen Elemente (1) von der der Hilfsschicht (7) abgewandten Seite des Körpers ausgehend soweit voneinander getrennt werden, daß der größte Teil ihrer jeweiligen Seitenflächen (8) freiliegt, und die elektronischen Elemente (1) durch zumindest einen Teil der Hilfsschicht (7) mechanisch zusammengehalten werden, und daß die freiliegenden Teile der Seitenflächen (8) bearbeitet werden.

2. Verfahren nach Anspruch 1, dadurch gekennzeichnet daß der Abstand zwischen benachbarten elektronischen Elementen (1) bzw. der Öffnungswinkel α dessen Schenkel durch die Seitenflächen (8) benachbarter elektronischer Elemente (1) gebildet wird, vor dem Bearbeiten der Seitenflächen vergrößert wird.

3. Verfahren nach Anspruch 2, dadurch gekennzeichnet, daß die elektronischen Elemente (1) zum Vergrößern des Öffnungswinkels α reihenweise über einen Gegenstand geführt werden, der entlang den jeweiligen Reihen eine Drehachse definiert und einen vorgegebenen Krummungsradius aufweist.

4. Verfahren nach einem der vorangehenden Ansprüche, dadurch gekennzeichnet, daß das Bearbeiten der Seitenflächen (8) durch Beschichten, insbesondere durch Metallisieren, durch Materialabtragen, durch Belichten und/oder durch Dotieren erfolgt.

5. Verfahren nach Anspruch 4, dadurch gekennzeichnet, daß das Beschichten der Seitenflächen (8) durch stromloses, galvanisches Abscheiden eines Metalls erfolgt.

6. Verfahren nach Anspruch 4 oder 5, dadurch gekennzeichnet, daß das abzuscheidende Metall in einer chemischen Lösung mittels eines flüssigen Strahls auf die Seitenflachen (8) aufgebracht und die überschüssige chemische Lösung gleichzeitig abgesaugt wird.

7. Verfahren nach einem der vorangehenden Ansprüche, dadurch gekennzeichnet, daß die Metallisierung durch Bedampfen oder Sputtern durch eine Blende erfolgt, die so angeordnet ist, daß die Oberfläche der elektronischen Elemente (1) nicht metallisiert wird.

8. Verfahren nach einem der Ansprüche 3 bis 7, dadurch gekennzeichnet, daß wenigstens eine weitere Metallschicht auf die metallisierten Seitenflächen (8) aufgebracht wird.

9. Verfahren nach einem der Ansprüche 3 bis 8, dadurch gekennzeichnet, daß gleichzeitig mit dem Metallisieren der Seitenflächen (8) der elektronischen Elemente (1) ihre Rückseite metallisiert wird.

10. Verfahren nach einem der vorangehenden Ansprüche, dadurch gekennzeichnet, daß die Hilfsschicht nach dem Bearbeiten der Seitenflächen (8) zwischen den elektronischen Elementen (1) durchtrennt wird.

11. Verfahren nach einem der vorangehenden Ansprüche, dadurch gekennzeichnet, daß die Hilfsschicht (7) auf der Vorderseite des Körpers aufgebracht wird, in der Hilfsschicht (7) Öffnungen (5) über den Kontakten der elektronischen Elemente (1) vorgesehen werden, und elektrische Parameter der elektronischen Elemente (1) vor dem Durchtrennen der Hilfsschicht (7) getestet werden.

12. Verfahren nach einem der Ansprüche 1 bis 10, dadurch gekennzeichnet, daß die Hilfsschicht (7) auf der Rückseite des abgedünnten Körpers aufgebracht wird, das Trennen der elektronischen Elemente (1) bis zu der Hilfsschicht erfolgt, und elektrische Parameter der elektronischen Elemente (1) vor dem Durchtrennen der Hilfsschicht getestet werden.

13. Verfahren nach einem der vorangehenden Ansprüche, dadurch gekennzeichnet, daß der Körper ein Halbleiterwafer ist.
